**Europäisches Patentamt**

**European Patent Office**

**Office européen des brevets**

(11) Veröffentlichungsnummer: **0 131 953**

**A1**

(12) **EUROPÄISCHE PATENTANMELDUNG**

(21) Anmeldenummer: **84108363.7**

(22) Anmeldetag: **16.07.84**

(51) Int. Cl.⁴: **H 03 K 19/094**

(30) Priorität: **18.07.83 DE 3325812**

(43) Veröffentlichungstag der Anmeldung:
**23.01.85 Patentblatt 85/4**

(84) Benannte Vertragsstaaten:
**AT BE CH DE FR GB IT LI NL**

(71) Anmelder: **Siemens Aktiengesellschaft
Berlin und München Wittelsbacherplatz 2
D-8000 München 2(DE)**

(72) Erfinder: **Wiedeburg, Klaus Hanno, Dr.-Ing.
Veilchenstrasse 7
D-8039 Puchheim(DE)**

(54) BFL-Logik-Schaltungsanordnung.

(57) Zur Auffächerung (Fan-Out) in einer in BFL-Technik realisierten GaAs-MESFET-Logik-Schaltung ist der Ausgang eines BFL-Verknüpfungsglieds 60 über einen BFL-Negator-Zweig I mit dem einen Eingang und direkt mit dem anderen Eingang einer GaAs-MESFET-Push-Pull-Stufe PP verbunden, an deren Ausgang jeweils über einen eigenen BFL-Buffer-Zweig die nachfolgenden BFL-Verknüpfungsglieder Gl,-Gm angeschlossen sind.

FIG 2

EP 0 131 953 A1

0131953

SIEMENS AKTIENGESELLSCHAFT   Unser Zeichen
Berlin und München          VPA  83 P 1 4 9 2 E

BFL-Logik-Schaltungsanordnung

Neuere Entwicklungen der Halbleiter-Technik haben zu integrierten Logik-Schaltungen mit GaAs-Metall-Halbleiter-
Feldeffekttransistoren, sog.MESFETs,  geführt, wobei man
heute im Prinzip vier GaAs-MESFET-Schaltungstechniken
unterscheidet (IEEE Journal of Solid-State Circuits
Vol. SC-17, No. 3, June 1982, S.569...584, 573):
    1) die sog. BFL(Buffered FET Logic)-Technik,
    2) die sog. SDFL(Schottky Diode FET Logic)-Technik,
    3) die sog. DCFL(Direct Coupled FET Logic)-Technik, und
    4) die sog. LPFL(Low Pinchoff-Voltage FET Logic)-Technik.

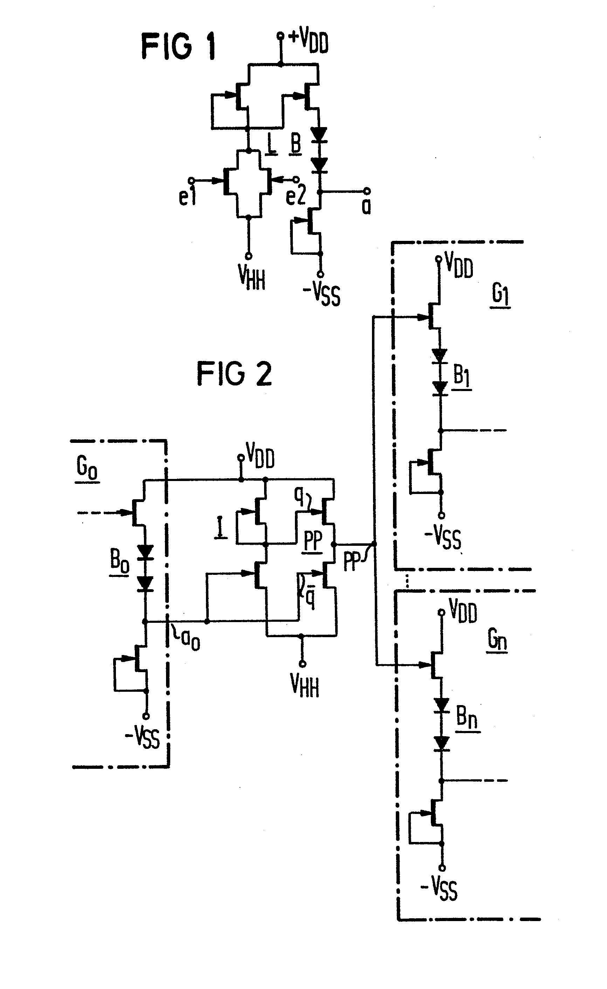

Die letzteren beiden GaAs-MESFET-Schaltungstechniken sehen
im Prinzip,
Anreicherungs-(Enhancement-)Transistoren vor, d.h. ohne
Gatespannung nichtleitende Transistoren, bei denen die
Kanalbildung durch eine Gatespannung bewirkt wird;
die ersteren beiden GaAs-MESFET-Schaltungstechniken sehen
Verarmungs-(Depletion-)Transistoren vor, d.h. aufgrund entsprechender Dotierung der Kanalzone ohne Gatespannung
leitende Transistoren, die durch eine Gatespannung gesperrt
werden. Verarmungstyp-Logikschaltungen, die eine zusätzliche Speisespannung zur Erzeugung der erforderlichen
Sperrspannung benötigen, zeigen im Prinzip einen zweistufigen Aufbau ihrer Verknüpfungsglieder; so besteht jedes BFL-Verknüpfungsglied aus dem eigentlichen Logik-
Zweig und einem nachfolgenden Buffer-(Treiber-)Zweig,
die dies auch aus der Zeichnung FIG 1 deutlich wird:

Die Zeichnung FIG 1 zeigt zur Verdeutlichung der
BFL-Technik ein in dieser Technik ausgeführtes NOR-Glied 29.6.83 Spr 1 Kel

0131953

83 P 1492 E

für zwei Eingangsvariable. Dieses NOR-Glied besteht aus
zwei Zweigen, dem mit zwei an ihren Steuerelektroden jeweils von einer Eingangsvariablen beaufschlagten, mit
ihren Hauptelektroden einander parallel geschalteten
MESFET-Eingangstransistoren und einem gemeinsamen
MESFET-Lasttransistor aufgebauten eigentlichen Logik-
Zweig und dem nachfolgenden, durch die Serienschaltung
eines MESFET-Lasttransistors, zweier Dioden und eines
vom Logik-Zweig L gesteuerten weiteren, als Source-Folger
geschalteten MESFET-Transistors gebildeten Buffer-Zweig B.
Der Buffer-Zweig (Treiberstufe) B liegt dabei zwischen
einer Source-Speisespannung $-V_{SS}$ und einer Drain-Speisespannung $V_{DD}$, an der auch der Logik-Zweig L liegt;
die Source-Elektroden der beiden Eingangstransistoren
des Logik-Zweiges L liegen an einer Hilfs-Versorgungsspannung $V_{HH}$, die auch durch Massepotential gegeben
sein kann. Nur wenn an beiden Eingängen e1 und e2
des NOR-Gliedes gemäß Fig.1 eine dem Wert O der Schaltvariablen entsprechende Sperrspannung (Low-Pegel) anliegt,
ist der vom Logik-Zweig L gesteuerte Transistor des
Buffer-Zweiges B so gut leitend, daß am Ausgang a des NOR-
Gliedes gemäß Fig.1 die dem Wert 1 der Schaltvariablen
entsprechende Ausgangsspannung (High-Pegel) auftritt.

Liegt an einem Eingang e eines BFL-Verknüpfungsgliedes
eine dem Wert 1 der Schaltvariablen entsprechende Eingangsspannung (High-Pegel) an, so ist die von der Gate-Source-
Strecke des betreffenden GaAs-MESFET-Eingangstransistors
gebildete Schottky-Diode in Durchlaßrichtung gepolt,
und es fließt ein entsprechender Durchlaßstrom vom
Schottky-Gate des Eingangsschalttransistors zur Hilfs-
Versorgungsspannungsquelle $V_{HH}$.
Wenn nun im Zuge einer BFL-Logik-Schaltung an ein
BFL-Verknüpfungsglied eine Mehrzahl nachfolgender Verknüpfungsglieder angeschlossen ist, so wird es durch
deren Durchlaßströme entsprechend belastet, was, statisch gesehen, seinen Ausgangssignalpegel verschlechtert und, dynamisch gesehen, die Low-High-Übergangszeit merklich erhöht; damit werden zum einen die Störsicherheit und zum anderen die Schaltgeschwindigkeit der Logik-Schaltung beeinträchtigt.

Um dem zu begegnen, kann man die Kanalweiten der Transistoren im Buffer-Zweig des BFL-Verknüpfungsgliedes vergrößern, so daß der Einfluß der Ausgangsbelastung geringer wird. Ein solches Vorgehen steigert indessen den Flächenbedarf der Schaltungsanordnung und führt außerdem zu einer Erhöhung der Verlustleitstung, bedingt durch den höheren zur Source-Speisespannungsquelle $-V_{SS}$ fließenden Strom.

Die Erfindung zeigt demgegenüber einen Weg, solche Beeinträchtigungen zu vermeiden. Die Erfindung betrifft eine BFL-Logik-Schaltungsanordnung mit durch jeweils einen BFL-Logik-Zweig und einen nachfolgenden BLF-Buffer-Zweig gebildeten BFL-Verknüpfungsgliedern; diese BFL-Logik-Schaltungsanordnung ist erfindungsgemäß dadurch gekennzeichnet, daß zur Auffächerung (Fan-Out) in der BFL-Logik-Schaltung der Ausgang des Buffer-Zweiges eines BFL-Verknüpfungsgliedes über einen BFL-Logik-Zweig, insbesondere über einen BFL-Negator-Zweig, mit dem Eingang in den einen Arm und direkt mit einem entsprechenden Verknüpfungseingang in den anderen Arm einer MESFET-Push-Pull-Stufe verbunden ist, an deren Ausgang jeweils über einen BFL-Buffer-Zweig die jeweils nachfolgenden BFL-Verknüpfungsglieder angeschlossen sind.

Die Erfindung bringt den Vorteil mit sich, ohne nachteiligen Ausgangspegeleinbruch, Schaltgeschwindigkeitsabfall, Flächenbedarf und/oder Verlustleistungsanstieg dennoch in einer BFL-Logik-Schaltung ein merkliches

0131953

83 P 1492 E

Fan-Out zu ermöglichen, wobei die Push-Pull-Stufe, durch die dabei allenfalls ein relativ geringer Querstrom fließt, zugleich auch höhere kapazitive Lasten, z.B. Verdrahtungskapazität, bewältigen kann; die der Push-Pull-Stufe nachfolgenden Buffer-Zweige brauchen jeweils nur ein BFL-Verknüpfungsglied zu treiben und können daher mit Transistoren kleiner Kanalweite realisiert werden.

Es sei an dieser Stelle bemerkt, daß es in der MOS-Transistor-Schaltungstechnik bekannt ist, im Rahmen eines sog. Bootstrap-Inverters dem mit einem MOS-Schalttransistor und einem in Serie dazu liegenden Lasttransistor aufgebauten MOS-Inverter (Negator) eine im Gegentakt betriebene MOS-Treiberstufe ("Push-Pull"-Stufe) nachzuschalten (Halbleiter-Elektronik Bd. 14 - Weiß, Horninger: Integrierte MOS-Schaltungen, Bild 4.18). Wollte man dieses Schaltungsprinzip auf einen GaAs-BFL-Inverter(Negator) übertragen, so würde man zu einer Schaltungsanordnung gelangen, in der der Eingang und der Ausgang eines BFL-Inverters, d.h. der Eingang des BFL-Negator-Zweiges und der Ausgang des zugehörigen BFL-Buffer-Gliedes, mit den beiden Eingängen einer BFL-Push-Pull-Stufe verbunden sind. Eine solche Schaltungsanordnung erweist sich jedoch im Hinblick auf die erreichbaren Signalpegel und auf die Schaltschwellen und die Diodeneigenschaften der GaAs-Feldeffekt-Transistoren als wenig günstig, und die Erfindung geht daher ihren anderen Weg.

Die Zeichnung Fig.2 zeigt ein Ausführungsbeispiel für eine BFL-Fan-Out-Schaltung gemäß der Erfindung. Gemäß Fig.2 ist der Ausgang des Buffer-Zweiges (vgl. Fig.1) Bo eines in Fig.2 nicht näher dargestellten BFL-Ver-knüpfungsgliedes $G_o$ über einen einfachen BFL-Negator-Zweig I (ohne nachfolgenden BFL-Buffer-Zweig) mit dem

0131953
83 P 1492 E

einen Eingang q und außerdem direkt mit dem anderen
Eingang $\bar{q}$ einer im Gegentakt betriebenen, zwischen der
Drain-Speisespannung $V_{DD}$ und der Hilfs-Speisespannung
$V_{HH}$ (vgl. Fig.1) liegenden GaAs-MESFET-Treiberstufe
(Push-Pull-Stufe) PP verbunden. An den Ausgang pp
dieser GaAs-MESFET-Push-Pull-Stufe PP ist eine Mehrzahl
von BFL-Buffer-Zweigen $B_1...B_n$ angeschlossen, die
jeweils zu einem im Zuge der BFL-Logik-Schaltung nachfolgenden BFL-Verknüpfungsglied $G_1...G_n$ führen; dabei
erfahren die am Ausgang pp der Push-Pull-Stufe PP
mit zwischen den Speisespannungspegeln $V_{DD}$ und $V_{HH}$
liegenden Signalpegeln auftretenden Signale in den
BFL-Buffer-Zweigen $B_1...B_n$ entsprechende Pegelverschiebungen auf Werte, die die Ansteuerung der nachfolgenden Verknüpfungsglieder $G_1...G_n$ ermöglichen.

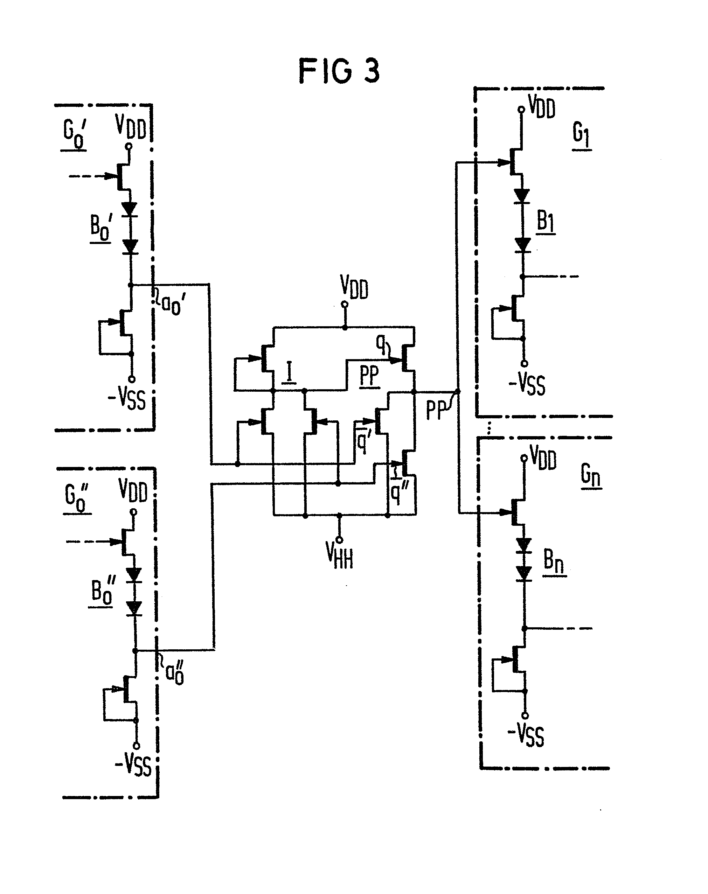

Wie die BFL-Logik-Schaltungsanordnung vor und hinter
der in Fig.2 skizzierten Auffächerung weiter ausgebildet
sein kann, braucht hier nicht näher betrachtet zu werden,
da dies zum Verständnis der Erfindung nicht erforderlich
ist. Es sei jedoch besonders bemerkt, daß der gemäß
Fig.2 dem BFL-Buffer-Zweig $B_0$ des BFL-Verknüpfungsgliedes $G_0$ nachgeschaltete, gemäß Fig2 durch den
BFL-Negator-Zweig I gebildete BFL-Logik-Zweig in Abweichung von der in Fig.2 gegebenen Darstellung auch
durch einen BFL-Logik-Zweig für mehrere, im Rahmen der
BFL-Logik-Schaltungsanordnung ohnehin zu verknüpfende
Eingangsvariable gebildet sein kann; die Push-Pull-
Stufe PP weist dann in entsprechender Weise anstelle
des einzigen genannten anderen Einganges $\bar{q}$ (in FIG 2)
mehrere derartige andere Eingänge zu der zwischen der
Hilfsspeisespannung $V_{HH}$ und dem Ausgang pp der Push-
Pull-Stufe PP liegenden, dann durch eine Mehrzahl von
MESFETransistoren gebildeten entsprechenden Verknüpfungsschaltung für die genannten mehreren Eingangsvariablen
auf. Ein Ausführungsbeispiel für eine NOR-Verknüpfung
zweier solcher Eingangsvariabler $a_0'$ und $a_0''$ zeigt FIG 3;

hier wird sowohl im BFL-Logik-Zweig I als auch in
der Push-Pull-Stufe PP jeweils durch eine Parallelschaltung zweier MESFETransistoren eine NOR-Verknüpfung
bewirkt. In entsprechender Weise sind beispielsweise
bei einer NAND-Verknüpfung anstelle der in FIG 3 vorgesehenen Parallelschaltung von MESFETransistoren entsprechende Serienschaltungen vorzusehen, was hier indessen nicht weiter dargestellt zu werden braucht.

0131953

83 P 1 4 9 2 E

## Patentansprüche

1. BFL-Logik-Schaltungsanordnung mit durch jeweils einen BFL-Logik-Zweig und einen nachfolgenden BFL-Buffer-Zweig gebildeten BFL-Verknüpfungsgliedern, d a - d u r c h   g e k e n n z e i c h n e t , daß zur Auffächerung (Fan-Out) in der BFL-Logik-Schaltung der Ausgang ($a_0$) des Buffer-Zweigs ($B_0$) eines BFL-Verknüpfungsgliedes ($G_0$) über einen BFL-Logik-Zweig (I) mit dem Eingang (q) in den einen Arm und direkt mit einem entsprechenden Verknüpfungseingang ($\overline{q}$) in den anderen Arm einer GaAs-MESFET-Push-Pull-Stufe (PP) verbunden ist, an deren Ausgang (pp) jeweils über einen BFL-Buffer-Zweig ($B_1...B_n$) die nachfolgenden BFL-Verknüpfungsglieder ($G_1...G_n$) angeschlossen sind.

2. BFL-Logik-Schaltungsanordnung nach Anspruch 1, d a - d u r c h   g e k e n n z e i c h n e t , daß der Ausgang ($a_0$) des BFL-Verknüpfungsglieds ($G_0$) über einen BFL-Negator-Zweig (I) mit dem einen Eingang (q) und direkt mit dem anderen Eingang ($\overline{q}$) der GaAs-MESFET-Push-Pull-Stufe (PP) verbunden ist.

0131953

FIG 1

FIG 2

FIG 3

Europäisches
Patentamt

**EUROPÄISCHER RECHERCHENBERICHT**

**0131953**
Nummer der Anmeldung

EP 84 10 8363

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| X | IEEE JOURNAL OF SOLID-STATE CIRCUITS, Band SC-16, Nr. 5, Oktober 1981, Seiten 578-584, IEEE, New York, USA; C.D. HARTGRING et al.: "Silicon MESFET digital circuit techniques" * Figuren 1c,3a,3b,4c,7; Seite 578, rechte Spalte, Zeilen 10-12; Seite 579, rechte Spalte, Zeilen 1-27; Seite 580, linke Spalte, Zeile 26 - rechte Spalte, Zeile 6; Seite 582, linke Spalte, Zeilen 34-43 * <br> --- | 1,2 | H 03 K 19/094 |
| X | IEEE TRANSACTIONS ON ELECTRON DEVICES, Band ED-27, Nr. 6, Juni 1980, Seiten 1074-1091, IEEE, New York, USA; K. LEHOVEC et al.: "Analysis of GaAs FET's for integrated logic" * Figur 19; Seite 1084, linke Spalte, Zeile 3 - Seite 1085, linke Spalte, Zeile 9 * <br> ----- | 1,2 | RECHERCHIERTE SACHGEBIETE (Int. Cl. ³) <br><br> H 03 K |

Der vorliegende Recherchenbericht wurde für alle Patentansprüche erstellt.

| Recherchenort <br> DEN HAAG | Abschlußdatum der Recherche <br> 01-10-1984 | Prüfer <br> FEUER F.S. |
|---|---|---|